# EUROPEAN PATENT SPECIFICATION

(11) **EP 4 336 346 B1**
(45) Date of publication and mention of the grant of the patent: **28.10.2026**
(21) Application number: 21953074.8
(22) Date of filing: 10.08.2021
(51) Int. Cl.: G06F 7/523

(54) **MULTIPLIER**
MULTIPLIZIERER
MULTIPLICATEUR

(43) Date of publication of application: 13.03.2024
(73) Proprietor: Huawei Technologies Co., Ltd., Shenzhen, Guangdong 518129 (CN)
(72) Inventor: FAN, Tuanbao, Shenzhen, Guangdong 518129 (CN); SHI, Xiaoshan, Shenzhen, Guangdong 518129 (CN); JIANG, Yuexing, Shenzhen, Guangdong 518129 (CN); JIANG, Mingfeng, Shenzhen, Guangdong 518129 (CN)
(74) Representative: Gill Jennings & Every LLP
(86) International application number: PCT/CN2021/111773
(87) International publication number: WO 2023/015442

(56) References cited:
- EP-A1- 4 030 277
- WO-A1-2021/097765
- WO-A1-2021/097765
- CN-A- 107 977 191
- CN-A- 110 515 587
- CN-A- 111 522 528
- US-A1- 2009 013 022
- US-A1- 2015 193 203

## Description

### TECHNICAL FIELD

This application relates to the field of electronic technologies, and in particular, to a multiplier.

### BACKGROUND

With continuous development and maturation of an artificial intelligence (AI) technology, the AI technology has been gradually popularized in communication devices such as a server and a terminal, and the AI technology has a high requirement on a computing capability of a processor such as a central processing unit (CPU), a neural-network processing unit (NPU), a graphics processing unit (GPU), or a digital signal processor (DSP) in the communication device. As a core computing unit of the processor, a multiplier plays an increasingly important role.

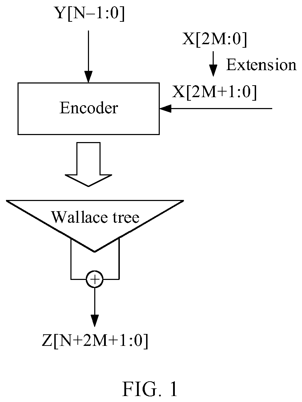

An existing multiplier architecture is designed based on a standard encoder and a standard adder. As shown in FIG. 1, implementation of a specific design may be summarized into three steps: (1) In an encoder, use a Radix-4 Booth algorithm to encode a multiplicand and a multiplier to obtain a plurality of partial product items; (2) Compress a permutation array including the plurality of partial product items by using a Wallace tree (Wallace tree); (3) Sum two accumulated values obtained by compressing the permutation array, to obtain a multiplication operation result. For a multiplier whose multiplier bit width is an odd number, 1-bit (bit) sign bit extension needs to be performed on the multiplier by using a precoder. In FIG. 1, the multiplicand is represented as a binary number Y[N-1:0] with a bit width of N bits, the multiplier is represented as a binary number X[2M:0] with a bit width of (2M+1) bits, a value of X[2M:0] obtained after the 1-bit sign bit extension is represented as X[2M+1:0], and the multiplication operation result is represented as Z[N+2M+1:0].

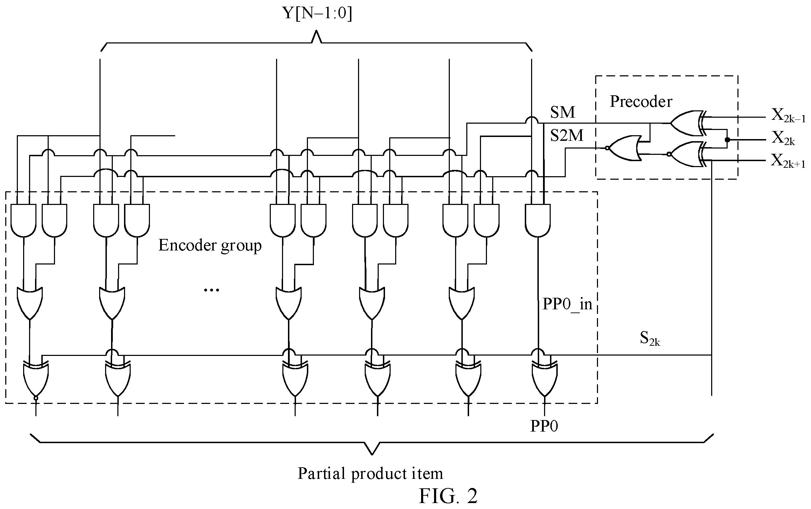

A decimal number val(X) corresponding to a binary number X[2M+1:0] may be represented as a formula (1), and X_{2M+1}, X_{2M}, ... , and X₀ in the formula correspondingly represent values on digits (or weights) in X[2M+1:0]. A principle of precoding the binary number X[2M+1:0] by the multiplier is: Each odd item in the formula (1) is decomposed by using a formula (2); each odd item after decomposition is substituted into the formula (1), and a formula (3) can be obtained; X₂ₖ₋₁, X₂ₖ, and X₂ₖ₊₁ in the formula (3) are used as a group of precoding items. Then, by using an encoder group shown in FIG. 2, a selection signal group (that is, SM and S2M) obtained after precoding of the group of precoding items (to be specific, X₂ₖ₋₁, X₂ₖ, and X₂ₖ₊₁) and values on different digits in Y[N-1:0] are multiplied to obtain a corresponding partial product PP[N-1:0]. PP0 in FIG. 2 represents a partial product obtained after multiplication of values on a digit 0 (namely, 2⁰) in Y[N-1:0], and S₂ₖ represents a sign bit corresponding to the group of precoding items. $val \left(X\right) = - {X}_{2 M + 1} ⋅ {2}^{2 M + 1} + {X}_{2 M} ⋅ {2}^{2 M} + ⋯ + {X}_{1} ⋅ {2}^{1} + {X}_{0} ⋅ {2}^{0}$ (1) ${X}_{i} ⋅ {2}^{i} = {X}_{i} ⋅ {2}^{i + 1} + \left(-2{X}_{i}\right) ⋅ {2}^{i - 1} , where i is an odd number$ (2) $val \left(X\right) = {\sum }_{0}^{M} \left({X}_{2 k - 1}+{X}_{2 k}-2{X}_{2 k + 1}\right) ⋅ {2}^{2 k}$ (3)

The multiplier generally includes a plurality of encoder groups, and a shape of a permutation array that includes a partial product and that is output by the plurality of encoder groups is scattered. In this way, when the permutation array is compressed by using the Wallace tree, the Wallace tree includes a larger quantity of compression layers. As a result, operation time of the multiplier is long and an area of the multiplier is large.

WO2021097765A1 discloses a multiplier and an operator circuit. The multiplier is used for realizing multiplication of a first value of M bits and a second value of N bits, and comprises P groups of encoders and W layers of inverse compressors; each group of encoders in the P groups of encoders comprises N encoders; each group of encoders is used for encoding a part of bits in the second value, and a group selection signal and a symbol control input signal corresponding to each group of encoders using a forward encoding operator or inverse encoding operator; the group selection signal and the symbol control input signal are generated according to a part of bits in the first value, and the P groups of encoders encode to obtain P partial product items; and the W layers of inverse compressors are used for compressing P partial product items using inverse compression operators to obtain two accumulated values, and the sum of the two accumulated values is a product of the first value and the second value.

### SUMMARY

This application provides a multiplier, to reduce operation time and an area of the multiplier. To achieve the foregoing objective, the following technical solutions are used in this application.

According to a first aspect, a multiplier is provided, configured to implement multiplication of a first value of N bits and a second value of W bits, where N and W are integers greater than 1, and the multiplier includes: P precoders, P encoder groups, and a compressor, where the P precoders are in a one-to-one correspondence with the P encoder groups, and P is an integer greater than 1; each precoder of the P precoders is configured to: precode at least two bits in the second value, to output a selection signal group; each encoder group of the P encoder groups is configured to: encode the first value and a selection signal group output by a precoder corresponding to the encoder group, to output a partial product item, where the partial product item includes a plurality of partial products, and the P encoder groups correspondingly output P partial product items, where the P encoder groups include a first encoder group, the first encoder group includes a first encoder, the first encoder is configured to: encode a first selection signal group, a least significant bit in the first value, and a first sign bit, to obtain a first partial product and a first output sign bit, wherein a digit corresponding to the first output sign bit is greater than a digit corresponding to the first sign bit and a difference value is 1, the first selection signal group is a selection signal group output by a first precoder of the P precoders, the first sign bit is one of the at least two bits used by the first precoder when performing encoding, and the first precoder corresponds to the first encoder group; and the compressor is configured to: compress the P partial product items, to obtain a plurality of accumulated values, where a sum of the plurality of accumulated values is a product of the first value and the second value.

In the foregoing technical solution, the P encoder groups include a first encoder group, the first encoder group includes a first encoder, and the first encoder is configured to encode a first selection signal group, a least significant bit in the first value, and a first sign bit in an encoding process. A partial product obtained by encoding the least significant bit and the first sign bit can be added in advance, so that a permutation array that includes a plurality of partial product items and is output by the P encoder groups is more centralized or regularized. In this way, a quantity of compression layers included in the compressor is reduced, an area of the multiplier is further reduced, and an operation speed of the multiplier is increased.

In a possible implementation of the first aspect, the first selection signal group includes a first selection signal, the first encoder includes a first NAND gate, a first NOT gate, and a first AND gate, and an output end of the first NAND gate is coupled to an input end of the first NOT gate and a first input end of the first AND gate, where two input ends of the first NAND gate are respectively configured to receive the least significant bit and the first selection signal, an output end of the first NOT gate is configured to output the first partial product, a second input end of the first AND gate is configured to receive the first sign bit, and an output end of the first AND gate is configured to output the first output sign bit. In the foregoing possible implementation, the provided first encoder is simple and effective, and can add the partial product obtained by encoding the least significant bit in the first value and the first sign bit in advance, so that the permutation array that includes a plurality of partial product items and is output by the P encoder groups is more centralized or regularized. In this way, the quantity of compression layers included in the compressor is reduced, the area of the multiplier is further reduced, and the operation speed of the multiplier is increased.

In a possible implementation of the first aspect, the P encoder groups include P-1 first encoder groups. Optionally, the 1^{st} encoder group to the (P-1)^{th} encoder group of the P encoder groups are all first encoder groups. In the foregoing possible implementation, the partial product obtained by encoding the least significant bit in the first value in different encoder groups and different first sign bits can be added in advance by using P-1 first encoder groups, so that the permutation array that includes a plurality of partial product items and is output by the P encoder groups is more centralized or regularized. In this way, the quantity of compression layers included in the compressor is reduced, the area of the multiplier is further reduced, and the operation speed of the multiplier is increased.

In a possible implementation of the first aspect, the first encoder is further configured to: encode the first output sign bit and a second sign bit, to obtain a second output sign bit, where the second sign bit is a sign bit used by a precoder corresponding to a next encoder group of the first encoder group when performing encoding, and a digit of the second sign bit in the partial product item is the same as a digit of the second output sign bit. In the foregoing possible implementation, the multiplier further encodes the first output sign bit and the second sign bit by using the first encoder, and encodes a constant 1 and a second partial product by using a second encoder, so that the permutation array that includes a plurality of partial product items and is output by the P encoder groups is further regularized. In this way, the quantity of compression layers included in the compressor is further reduced, to further reduce the area of the multiplier, and increase the operation speed of the multiplier.

In a possible implementation of the first aspect, the first encoder further includes an OR gate; and two input ends of the OR gate are respectively configured to receive the first output sign bit and the second sign bit, an output end of the OR gate is configured to output the second output sign bit. Optionally, the (P-1)^{th} encoder group of the P encoder groups is the first encoder group. In the foregoing possible implementation, the provided first encoder is simple and effective, and can encode the first output sign bit and the second sign bit, so that the permutation array that includes a plurality of partial product items and is output by the P encoder groups is more centralized or regularized. In this way, the quantity of compression layers included in the compressor is reduced, the area of the multiplier is further reduced, and the operation speed of the multiplier is increased.

In a possible implementation of the first aspect, at least one encoder group of the P encoder groups further includes a second encoder; and the second encoder is configured to: encode the constant 1 and the second partial product, to obtain a third partial product and a fourth partial product, where the second partial product is a sign extension bit in a partial product item output by an encoder group in which the second encoder is located or a partial product corresponding to an encoded bit in the first value, the third partial product and the second partial product correspond to a same digit, and a digit corresponding to the fourth partial product is greater than the digit corresponding to the third partial product and a difference value is 1. In the foregoing possible implementation, the constant 1 and the second partial product are encoded by using the second encoder, so that the permutation array that includes a plurality of partial product items and is output by the P encoder groups is further regularized. In this way, the quantity of compression layers included in the compressor is further reduced, to further reduce the area of the multiplier, and increase the operation speed of the multiplier.

In a possible implementation of the first aspect, the second encoder includes a second NOT gate; and an input end of the second NOT gate is configured to receive the second partial product, an output end of the second NOT gate is configured to output the third partial product, and the fourth partial product is equal to the second partial product. In the foregoing possible implementation, the constant 1 and the second partial product are encoded by using the second NOT gate, so that the permutation array that includes a plurality of partial product items and is output by the P encoder groups is further regularized.

In a possible implementation of the first aspect, W is an odd number. In the foregoing possible implementation, an area of a multiplier whose multiplier bit width is an odd number can be reduced, and an operation speed of the multiplier can be increased.

In a possible implementation of the first aspect, the P encoder groups further include a second encoder group, and the second encoder group is different from the first encoder group.

In a possible implementation of the first aspect, the multiplier further includes a summation circuit, configured to: receive the plurality of accumulated values, and sum the plurality of accumulated values to obtain the product.

According to a second aspect, a processor is provided, where the processor includes the multiplier provided in any one of the first aspect or the possible implementations of the first aspect.

According to a third aspect, a communication device is provided. The communication device comprises the multiplier provided in any one of the first aspect or the possible implementations of the first aspect.

It may be understood that any processor, or communication device provided in the foregoing includes the multiplier provided in the foregoing. Therefore, for beneficial effects that can be achieved by the processor, processor, or communication device, refer to beneficial effects of the multiplier provided in the foregoing. Details are not described herein again.

### BRIEF DESCRIPTION OF DRAWINGS

FIG. 1 is a schematic diagram of an architecture of a multiplier;
FIG. 2 is a schematic diagram of a structure of a group of encoders;
FIG. 3 is a schematic diagram of a structure of a 9 bits×9 bits multiplier;
FIG. 4 is a schematic diagram of a structure of a communication device according to an embodiment of this application;
FIG. 5 is a schematic diagram of a structure of a multiplier according to an embodiment of this application;
FIG. 6 is a schematic diagram of a structure of a precoder according to an embodiment of this application;
FIG. 7 is a schematic diagram of a structure of a first encoder group according to an embodiment of this application;
FIG. 8 is a schematic diagram of a structure of a second encoder group according to an embodiment of this application;
FIG. 9 is a schematic diagram of a permutation array and a compressor according to an embodiment of this application;
FIG. 10 is a schematic diagram of a structure of another first encoder group according to an embodiment of this application;
FIG. 11 is a schematic diagram of adding a constant 1 and a partial product according to an embodiment of this application;
FIG. 12 is a schematic diagram of a structure of still another first encoder group according to an embodiment of this application;
FIG. 13 is a schematic diagram of a structure of yet another first encoder group according to an embodiment of this application;
FIG. 14 is a schematic diagram of another permutation array and another compressor according to an embodiment of this application;
FIG. 15A to FIG. 15E are schematic diagrams of structures of different precoders and encoder groups in a multiplier according to an embodiment of this application; and
FIG. 16 is a schematic diagram of a compressor according to an embodiment of this application.

### DESCRIPTION OF EMBODIMENTS

In this application, "at least one" means one or more, and "a plurality of" means two or more. "And/or" describes an association relationship between associated objects, and indicates that three relationships may exist, for example, A and/or B may indicate the following cases: A exists alone, both A and B exist, and B exists alone, where A and B may be singular or plural. "At least one of the following items (pieces)" or a similar expression thereof means any combination of these items, including any combination of singular items (pieces) or plural items (pieces). For example, at least one of a, b, or c may indicate: a, b, c, a and b, a and c, b and c, or a, b, and c, where a, b, and c may be singular or plural. In addition, in embodiments of this application, words such as "first" and "second" are used to distinguish between objects with similar names, functions, or effects. A person skilled in the art may understand that the words such as "first" and "second" do not limit a quantity and an execution sequence. The term "couple" indicates an electrical connection, including a direct connection through a conducting wire or a connecting end, or an indirect connection through another component. Therefore, "coupling" should be considered as an electronic communication connection in a broad sense.

Before embodiments of this application are described, a technology related to a multiplier whose multiplier bit width is an odd number in the current technology is first described.

In the current multiplier whose multiplier bit width is an odd number, 1-bit (bit) sign bit extension needs to be performed on a multiplier by using a precoder, a multiplicand and the extended multiplier are encoded by using a plurality of encoder groups to obtain a plurality of partial product items, and a permutation array including the plurality of partial product items is then compressed by using a Wallace tree (also referred to as a compressor). Specifically, the Wallace tree includes a plurality of compression layers. A plurality bits at a same compression layer are compressed in parallel by using a plurality of standard adders separately. After every three bits are compressed by using one standard adder, one carry output bit and one sum output bit are output.

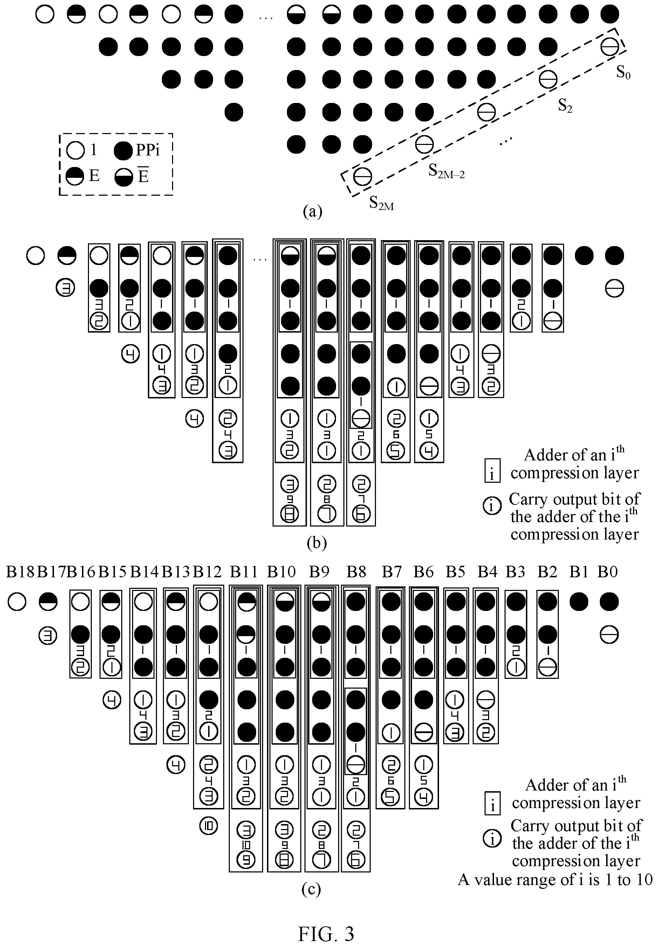

For example, the permutation array output by the plurality of encoder groups in the current multiplier is shown in (a) in FIG. 3, and the plurality of compression layers included in the Wallace tree are shown in (b) in FIG. 3. If the multiplier is a 9 bits×9 bits multiplier, the plurality of compression layers in the Wallace tree are shown in (c) in FIG. 3. In FIG. 3, B0 to B18 correspondingly represent different digits (to be specific, 2⁰ to 2¹⁸), and different points in the permutation array represent different types of partial products (for example, PPi, a constant 1, a sign extension bit E, an inverse phase *E̅* of the sign extension bit E, and a sign bit S). Rectangles with different numbers in the Wallace tree represent adders at different compression layers (for example, the 1^{st} compression layer to the 10^{th} compression layer), rectangles with a same number represent different adders at a same compression layer, and circles with different numbers represent carry output bits obtained by performing compression by the adders at the different compression layers. It can be learned from (c) in FIG. 3 that, in the 9 bits×9 bits multiplier, the Wallace tree includes 10 compression layers, and the 10 compression layers include 37 adders in total. It should be noted that the digit may also be referred to as a weight, and the digit is for bits in different places in a binary system, and is similar to a ones place, a tens place, a hundreds place, and the like in a decimal system.

Because a digit of a sign bit (for example, a plurality of sign bits S in the permutation array shown in (a) in FIG. 3) generated after encoding of each encoder group in the current multiplier is mapped to a digit corresponding to a partial product obtained by encoding the least significant bit of the multiplier, a shape of the permutation array is scattered. In this way, when the permutation array is compressed by using the Wallace tree, the Wallace tree includes a larger quantity of compression layers. As a result, operation time of the multiplier is long and an area of the multiplier is large. In view of this, this application provides a multiplier. By encoding a partial product obtained by encoding the sign bit and the least significant bit in an encoding process, the shape of the encoded permutation array is centralized, so that the quantity of compression layers included in the Wallace tree for compressing the permutation array is reduced, the area of the multiplier is further reduced, and an operation speed of the multiplier is increased. The multiplier provided in this application may be applied to a communication device. For specific descriptions of the communication device and the multiplier, refer to the following specification.

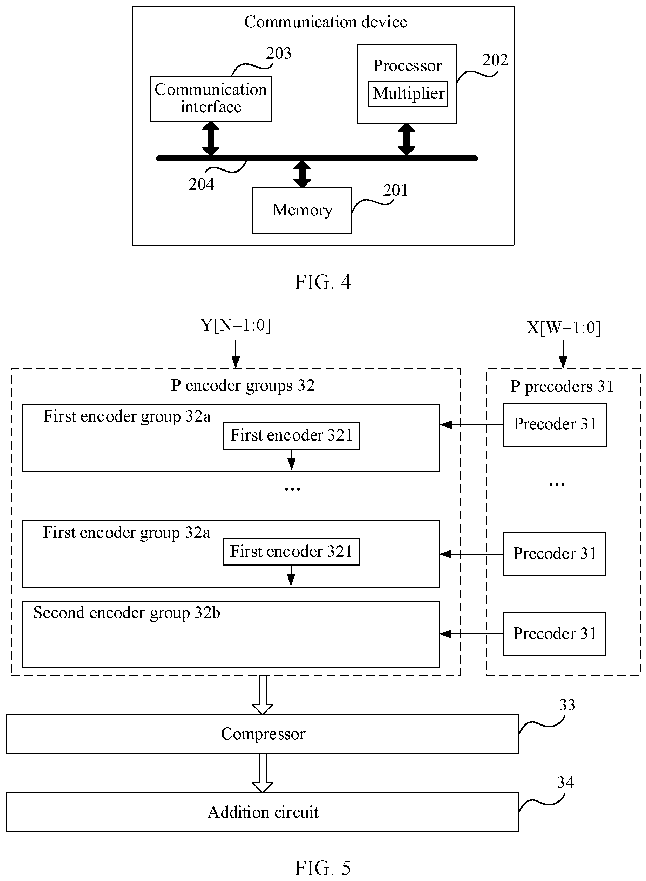

FIG. 4 is a schematic diagram of a structure of a communication device according to an embodiment of this application. The communication device may be a terminal, a server, or the like, or may be a chip, a chipset, a circuit board, a module, or the like in a terminal or a server. Refer to FIG. 4. The communication device may include a memory 201, a processor 202, a communication interface 203, and a bus 204. The memory 201, the processor 202, and the communication interface 203 are connected to each other by using the bus 204. The memory 201 may be configured to: store data, a software program, and a module, and mainly includes a program storage area and a data storage area. The program storage area may store an operating system, an application program required by at least one function, and the like. The data storage area may store data created when the device is used, and the like. The processor 202 is configured to: control and manage an action of the communication device, for example, execute various functions of the device and process data by running or executing the software program and/or the module stored in the memory 201 and invoking the data stored in the memory 201. The communication interface 203 is configured to support the device in performing communication.

The processor 202 includes but is not limited to a central processing unit (CPU), a network processing unit (NPU), a graphics processing unit (GPU), a digital signal processor (DSP), a general-purpose processor, or the like. The processor 202 includes one or more multipliers, for example, includes a multiplier array. The multiplier is a component that implements a multiplication operation in the processor 202.

The bus 204 may be a peripheral component interconnect (PCI) bus, an extended industry standard architecture (EISA) bus, or the like. The bus may be classified into an address bus, a data bus, a control bus, and the like. For ease of representation, only one thick line is used in FIG. 4 for representation, but it does not indicate that there is only one bus or only one type of bus.

To further describe the technical solution, FIG. 5 is a schematic diagram of a structure of a multiplier according to an embodiment of this application. The multiplier may be configured to implement multiplication of a first value Y[N-1:0] of N bits (bits) and a second value X[W-1:0] of W bits, where N and W are integers greater than 1. Refer to FIG. 5. The multiplier includes P precoders 31, P encoder groups 32, and a compressor 33, where the P precoders 31 and the P encoder groups 32 are in a one-to-one correspondence, and P is an integer greater than 1.

Each precoder 31 of the P precoders 31 is configured to: precode at least two bits in the second value X[W-1:0], to output a selection signal group. The P precoders 31 correspondingly output P selection signal groups.

A bit width of the second value X[W-1:0] may be an odd number or an even number. The at least two bits may be two adjacent bits or three adjacent bits. For example, the P precoders 31 include two precoders, and the second value is a binary number X[3:0] of four bits. In this case, the 1^{st} precoder may be configured to encode the 0^{th} and the 1^{st} bits (to be specific, X₀ and X₁) in X[3:0], and the 2^{nd} precoder may be configured to encode the 1^{st} to the 3^{rd} bits (to be specific, X₁, X₂, and X₃) in X[3:0].

In addition, the selection signal group may include a first selection signal SM, or include the first selection signal SM and a second selection signal S2M. The first selection signal SM and the second selection signal S2M may be two different signals.

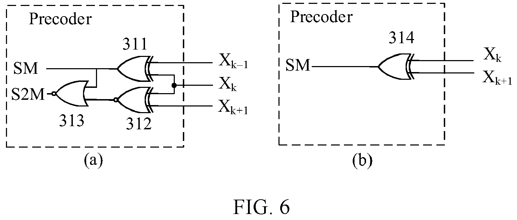

Optionally, the P precoders 31 include different precoders. In an example, as shown in (a) in FIG. 6, the precoder is configured to output SM and S2M, and the precoder 31 includes an XOR gate 311, an XNOR gate 312, and a NOR gate 313, where a first input end of the XOR gate 311 is configured to receive Xₖ₋₁, a second input end of the XOR gate 311 is coupled to a first input end of the XNOR gate 312 and is configured to receive Xₖ, a second input end of the XNOR gate 312 is configured to receive Xₖ₊₁, an output end of the XOR gate 311 and an output end of the XNOR gate 312 are respectively coupled to two input ends of the NOR gate 313, the output end of the XOR gate 311 is configured to output SM, and the output end of the NOR gate 313 is configured to output S2M. In another example, as shown in (b) in FIG. 6, the precoder may be configured to output SM, and the precoder 31 includes an XOR gate 314, where a first input end of the XOR gate 314 is configured to receive Xₖ, a second input end of the XOR gate 314 is configured to receive Xₖ₊₁, and an output end of the XOR gate 314 is configured to output SM. Xₖ₋₁, Xₖ, and Xₖ₊₁ in FIG. 6 represent adjacent bits in the second value, and k is a positive integer less than W.

Each encoder group 32 of the P encoder groups 32 is configured to: encode the first value and the selection signal group output by the precoder 31 corresponding to the encoder group 32, to output one partial product item, where the partial product item includes a plurality of partial products. The P encoder groups 32 correspondingly output P partial product items.

The P encoder groups 32 include at least one first encoder group 32a, and the at least one first encoder group 32a may be any one or more encoder groups 32 of the P encoder groups 32. Optionally, in FIG. 5, an example in which the at least one first encoder group 32a includes P-1 first encoder groups 32a, and the P-1 first encoder groups 32a are the 1^{st} to the (P-1)^{th} encoder groups of the P encoder groups 32 is used for description.

Specifically, for each first encoder group 32a of the at least one first encoder group 32a, the first encoder group 32a includes a first encoder 321. The first encoder 321 is configured to: encode a first selection signal group, a least significant bit in the first value, and a first sign bit, to obtain a first partial product PP0' and a first output sign bit, where a digit corresponding to the first output sign bit is greater than a digit corresponding to the first sign bit and a difference value is 1. The first selection signal group is a selection signal group output by a first precoder 31 of the P precoders 31, the first sign bit is one of at least two bits used by the first precoder when performing encoding, and the first precoder corresponds to the first encoder group 32a. It should be noted that the first encoder group 32a may include a plurality of encoders, the first encoder 321 may be an encoder that is in the plurality of encoders and that is configured to encode the least significant bit in the first value, and another encoder in the plurality of encoders than the first encoder 321 may be implemented by using the current technology. This is not specifically limited in this embodiment of this application.

In other words, the first encoder 321 may be configured to add *̅P̅P̅*̅0̅ (where PP0 represents a partial product obtained by encoding the least significant bit Y₀ by using the current technology, and *̅P̅P̅*̅0̅ represents negation of PP0) and the first sign bit S₂ₖ in an encoding process, a sum output bit generated after the addition is the first partial product PP0', and a carry output bit generated after the addition is a first output sign bit S₂ₖ'. A result of adding PP0' and S₂ₖ' is equal to a result of adding PP0 and S₂ₖ. Therefore, after the first encoder 321 is used, it can be ensured that a final product is correct. A specific principle is as follows: It can be learned from FIG. 2 that PP0 meets a formula (4), and ⊕ represents an XOR operation; S₂ₖ is added to both sides of the equation in the formula (4) to obtain a formula (5); the right side of the equation in the formula (5) is calculated according to a formula (6); and for a calculation result of the formula (6), if S₂ₖ'=S₂ₖ× *PP*0*_in,* and PP0'=PP0_in, PP0+S₂ₖ=PP0'+S₂ₖ' may be obtained. In the formula, PP0_in represents a bit value before encoding of PP0 and S₂ₖ in FIG. 2, and *S̅₂̅ₖ̅* represents an inverse phase of S₂ₖ. $PP 0 = {S}_{2 k} ⊕ PP 0 _ in$ (4) $\begin{matrix}{S}_{2 k} + PP 0 = {S}_{2 k} + {S}_{2 k} ⊕ PP 0 _ in \left(5\right) \\ = {S}_{2 k} + {S}_{2 k} \times \overline{PP 0 _ in} + \overline{{S}_{2 k}} \times PP 0 _ in \\ = {S}_{2 k} \times \left(PP0_in+\overline{PP 0 _ in}\right) + {S}_{2 k} \times \overline{PP 0 _ in} + \overline{{S}_{2 k}} \times PP 0 _ in \\ = 2 \times {S}_{2 k} \times \overline{PP 0 _ in} + {S}_{2 k} \times PP 0 _ in + \overline{{S}_{2 k}} \times PP 0 _ in \left(6\right) \\ = 2 \times {S}_{2 k} \times \overline{PP 0 _ in} + \left({S}_{2 k}+\overline{{S}_{2 k}}\right) \times PP 0 _ in \\ = 2 \times {S}_{2 k} \times \overline{PP 0 _ in} + PP 0 _ in\end{matrix}$

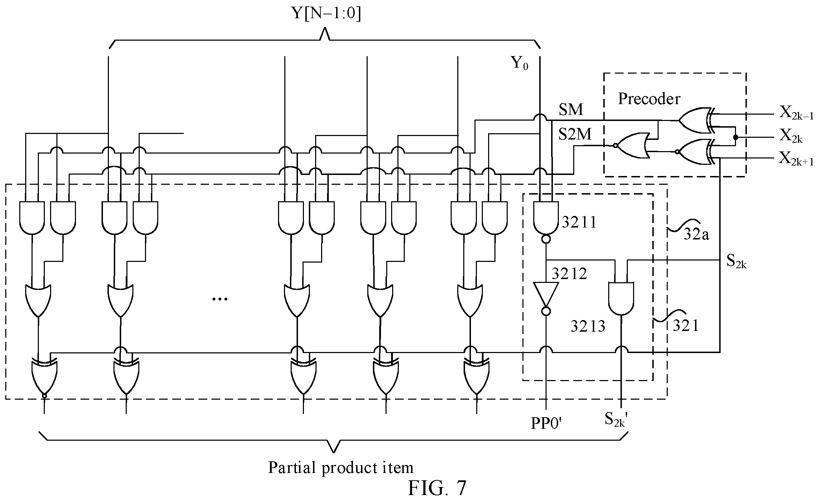

In an embodiment, as shown in FIG. 7, the first encoder 321 includes a NAND gate 3211, a NOT gate 3212, and an AND gate 3213, where an output end of the NAND gate 3211 is coupled to an input end of the NOT gate 3212 and a first input end of the AND gate 3213. Two input ends of the NAND gate 3211 are respectively configured to receive the least significant bit Y₀ and SM in the first selection signal group, an output end of the NOT gate 3212 is configured to output the first partial product PP0', a second input end of the AND gate 3213 is configured to receive the first sign bit S₂ₖ (where k is an integer), and an output end of the AND gate 3213 is configured to output the first output sign bit S₂ₖ'. It should be noted that FIG. 7 further shows another encoder than the first encoder 321 in the first encoder group 32. A structure of the another encoder is merely an example, and constitutes no limitation on this embodiment of this application.

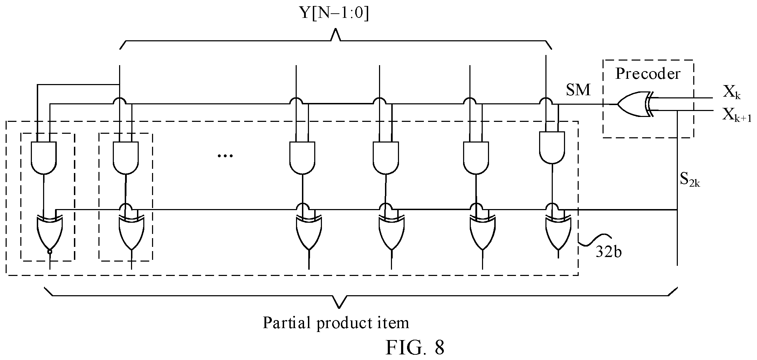

Optionally, the P encoder groups 32 further include one or more second encoder groups 32b, where the second encoder group 32b is different from the first encoder group 32a, and the second encoder group 32b does not include the first encoder 321. An encoder group other than the at least one first encoder group 32a of the P encoder groups 32 may be the second encoder group 32b. The second encoder group 32b may be implemented by using the current technology. This is not specifically limited in this embodiment of this application. In FIG. 5, an example in which the P^{th} encoder group of the P encoder groups 32 is the second encoder group 32b is used for description. For example, the second encoder group 32b includes a plurality of encoders, and the plurality of encoders may include encoders of different structures. For example, as shown in FIG. 8, the second encoder group 32b may include two types of encoders. The first type of encoder includes an AND gate and an XNOR gate, the second type of encoder includes an AND gate and an XOR gate, and each second encoder group 32b is configured to: encode the first value Y[N-1: 0] and SM and the sign bit S₂ₖ that are output by a corresponding precoder, to obtain a partial product item. The second encoder group 32b shown in FIG. 8 is merely an example, and constitutes no limitation on this embodiment of this application.

The compressor 33 is configured to compress the P partial product items to obtain a plurality of accumulated values, where a sum of the plurality of accumulated values is a product of the first value Y[N-1:0] and the second value X[W-1:0].

The compressor 33 may include Q compression layers, and Q is a positive integer. When Q is equal to 1, the compressor 33 includes a first compression layer, where the first compression layer is configured to: compress each digit in the permutation array of the plurality of partial product items in an ascending order of digits, to obtain a first compression array, where each row in the first compression array is an accumulated value. Each row in the permutation array of the plurality of partial products includes one partial product item, each column includes a plurality of bits corresponding to a same digit in the plurality of partial product items, and one partial product item includes a plurality of partial products output by one encoder group. When Q is an integer greater than 1, the compressor 33 includes a first compression layer to a Q^{th} compression layer. The first compression layer is configured to: compress each digit in the permutation array of the plurality of partial product items in an ascending order of digits, to obtain a first compression array; a j^{th} compression layer is configured to: compress each bit in a (j-1)^{th} compression array in the ascending order of digits, to obtain a j^{th} compression array, where a value range of j is 2 to W, and the Q^{th} compression array may include two or more rows, and each row corresponds to one accumulated value, so that the Q^{th} compression array includes a plurality of accumulated values.

Specifically, each compression layer compresses each digit for three bits on the digit, and a carry output bit and a current sum bit that are obtained by compression of the compression layer are not compressed. For example, for every three bits of each digit, each adder (using a standard adder as an example) in the compression layer is specifically configured to perform the following compression: if all the three bits are 0, the carry output bit is 0, and the current sum output bit is 0; if the three bits are all 1, the carry output bit is 1, and the current sum output bit is 1; if one of the three bits is 1 and the other two bits are 0, the carry output bit is 0, and the current sum output bit is 1; and if two of the three bits are 1 and the other bit is 0, the carry output bit is 1, and the current sum output bit is 1.

It should be noted that the carry output bit is an output bit of a next digit of a current compression digit, and the current sum output bit is an output bit of the current compression digit after the current compression digit is compressed. For example, it is assumed that the current compression digit is 2⁵, the next digit of the current compression digit is 2⁶, and three bits corresponding to 2⁵ are compressed. If the three bits are all 1, a current sum output bit of which bit is 1 is correspondingly generated on the compressed 2⁵, and a carry output bit of which bit is 1 is generated on 2⁶.

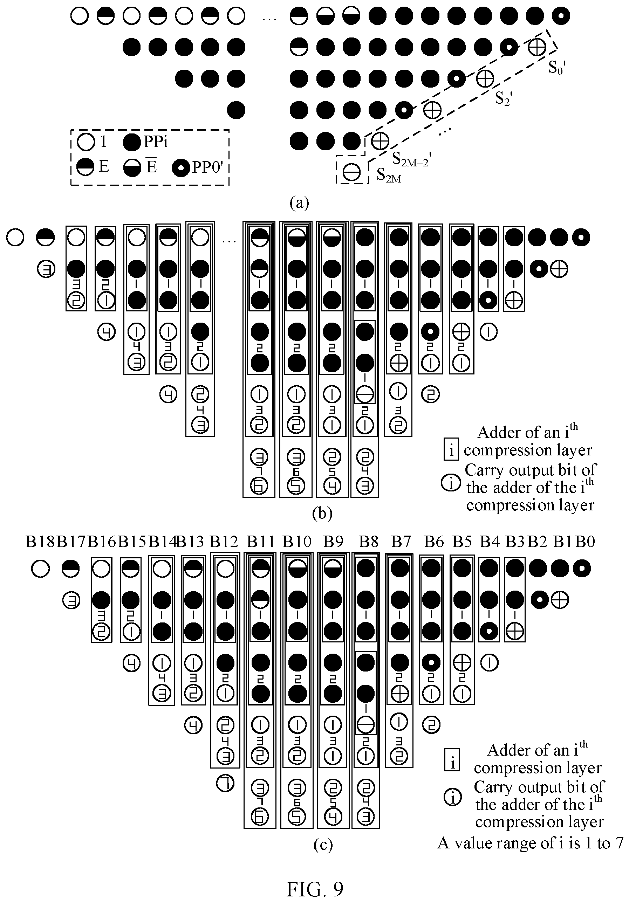

For ease of understanding, an example in which N=2M+1, and the 1^{st} to the (P-1)^{th} encoder groups of the P encoder groups 32 are all the first encoder groups 32a is used. A permutation array corresponding to a plurality of partial product items output by the P encoder groups 32 is shown in (a) in FIG. 9. Through comparing (a) in FIG. 9 with (a) in FIG. 3, it can be learned that digits of a plurality of output sign bits (that is, S₀' to S_{2M}') shown in (a) in FIG. 9 are mapped to digits corresponding to partial products obtained by encoding a second least significant bit of a multiplier. In other words, S₀' to S_{2M}' are respectively moved forward by one digit of each sign bit compared with a plurality of sign bits S shown in FIG. 3(a). In this way, a shape of the permutation array is centralized or more regularized. Correspondingly, (b) in FIG. 9 shows a plurality of compression layers included in the compressor 33 for compressing the permutation array and an adder in each compression layer. If the multiplier is a 9 bits×9 bits multiplier, as shown in (c) in FIG. 9, the compressor 33 includes seven compression layers, and the seven compression layers include 34 adders in total. Therefore, compared with the current technology, the multiplier provided in this application reduces a quantity of compression layers included in the compressor 33 and a total quantity of adders, so that an area of the multiplier is reduced and an operation speed of the multiplier is increased. In FIG. 9, B0 to B18 correspondingly represent different digits (to be specific, 2⁰ to 2¹⁸), and different points in the permutation array represent different types of partial products (for example, PPi, PP0', a constant 1, a sign extension bit E, and an inverse phase *E̅* of the sign extension bit E). Rectangles with different numbers in the compressor 33 represent adders at different compression layers, (for example, the 1^{st} compression layer to the 7^{th} compression layer), rectangles with a same number represent different adders at a same compression layer, and circles with different numbers represent carry output bits obtained by performing compression by the adders at the different compression layers.

Optionally, the multiplier further includes: an addition circuit 34, configured to: receive the plurality of accumulated values, and sum the plurality of accumulated values, to obtain the product of the first value Y[N-1:0] and the second value X[W-1:0]. For example, the plurality of accumulated values are two accumulated values, the addition circuit 34 is an adder, and the adder is used to: receive the two accumulated values, and sum the two accumulated values, to obtain the product of the first value Y[N-1: 0] and the second value X[W-1:0].

Further, the first encoder 321 is further configured to: encode the first output sign bit and a second sign bit, to obtain a second output sign bit, where the second sign bit is a sign bit output by a precoder corresponding to a next encoder group of the first encoder group 31a in which the first encoder 321 is located, a digit of the second sign bit in a corresponding partial product item is the same as a digit corresponding to the second output sign bit, and a digit corresponding to the first output sign bit is the same as a digit corresponding to the second output sign bit. Optionally, the (P-1)^{th} encoder group 32 of the P encoder groups 32 may include the first encoder 321.

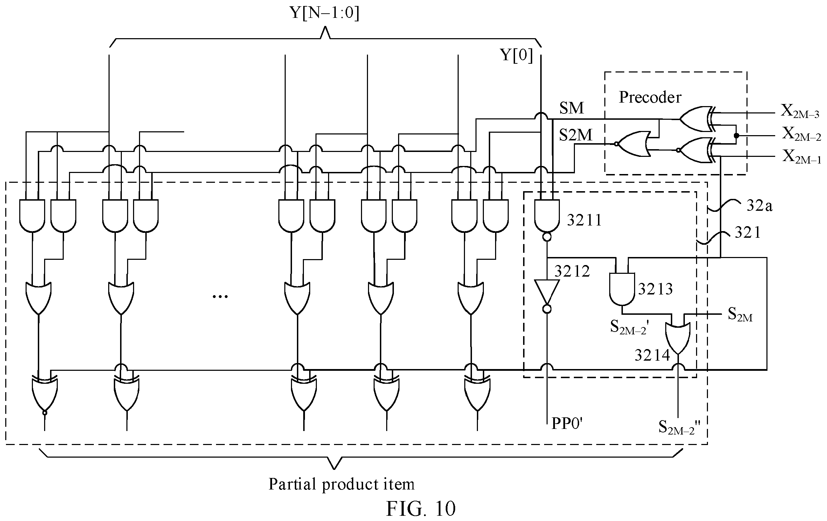

In an embodiment, with reference to FIG. 7, as shown in FIG. 10, when W is an odd number, W=2M+1, and the first encoder 321 is the (P-1)^{th} encoder group 32, the first encoder 321 further includes an OR gate 3214. Two input ends of the OR gate 3214 are respectively configured to receive a first output sign bit S_{2M-2}' and a second sign bit S_{2M}, and an output end of the OR gate 3214 is configured to output a second output sign bit S_{2M-2}", where a digit of the second sign bit S_{2M} in a corresponding partial product is the same as a digit corresponding to the second output sign bit S_{2M-2}", and a digit corresponding to the second output sign bit S_{2M-2}" is the same as a digit corresponding to the first output sign bit S_{2M-2}'. X_{2M-1}, X_{2M-2}, and X_{2M-3} represent at least two bits precoded by a precoder 31 corresponding to the (P-1)^{th} encoder group 32.

In other words, using k=M as an example, the first encoder 321 is further configured to split the second sign bit S_{2M} and the first output sign bit S_{2M-2}' into the second output sign bit S_{2M-2}" in an encoding process. Specific analysis is as follows: When S_{2M-2}'=1, X_{2M-1}=1; and when X_{2M-1}=1, no matter whether X_{2M} is equal to 1 or 0, S_{2M}=0 exists. Therefore, S_{2M-2}' and S_{2M} are not 1 at the same time. Therefore, S_{2M}×2^{2M} is split into two S_{2M}×2^{2M-1}. Because S_{2M-2}' and S_{2M} are not 1 at the same time, S_{2M-2}' and one S_{2M} obtained through splitting can be combined into S_{2M-2}" by using the OR gate 3214, and the other S_{2M} obtained through splitting is output as another output sign bit to a digit corresponding to the second output sign bit S_{2M-2}".

Further, at least one of the P encoder groups 32 further includes a second encoder 322. The second encoder 322 is configured to: encode the constant 1 and a second partial product, to obtain a third partial product and a fourth partial product, where the second partial product is a sign extension bit in a partial product item output by an encoder group in which the second encoder 322 is located or a partial product corresponding to an encoded bit in the first value, the third partial product and the second partial product correspond to a same digit, and a digit corresponding to the fourth partial product is greater than the digit corresponding to the third partial product and a difference value is 1.

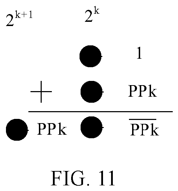

In other words, as shown in FIG. 11, the second encoder 322 may be configured to add the constant 1 and the second partial product in the encoding process. A sum output bit generated after the addition is the third partial product, a carry output bit after the addition is the fourth partial product, the third partial product is an inverse phase of the second partial product, and the fourth partial product is equal to the second partial product. In FIG. 11, the second partial product is represented as PPk, the third partial product is represented as *P̅P̅k̅,* the fourth partial product is represented as PPk, a digit corresponding to the second partial product and the third partial product is represented as 2^{k}, and a digit corresponding to the fourth partial product is represented as 2^{k+1}.

In an embodiment, the second encoder 322 includes a NOT gate 3221. An input end of the NOT gate 3221 is configured to receive the second partial product, an output end of the NOT gate 3221 is configured to output the third partial product, and the fourth partial product is equal to the second partial product. Optionally, the second encoder 322 further includes another gate circuit. When the second partial product is a sign extension bit or a partial product corresponding to an encoded bit in the first value, a structure of the second encoder 322 is different.

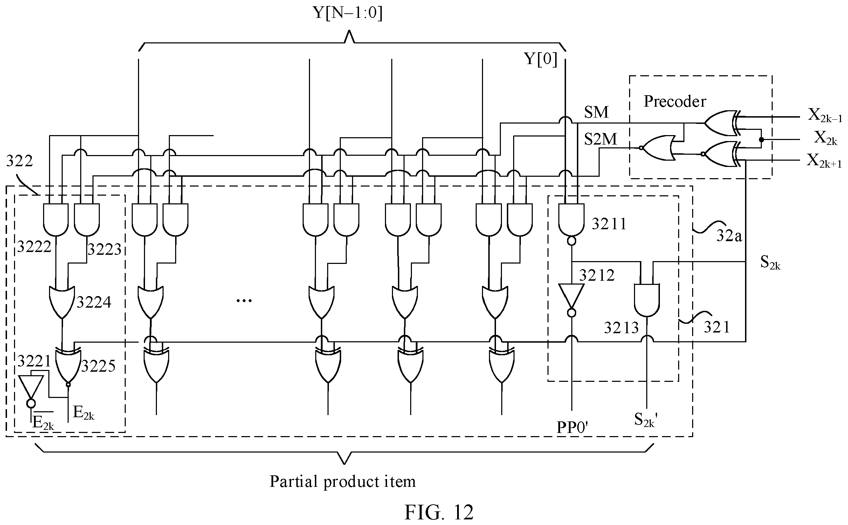

In an example, as shown in FIG. 12, the second partial product is a sign extension bit E₂ₖ, and the second encoder 322 further includes a first AND gate 3222, a second AND gate 3223, an OR gate 3224, and an XNOR gate 3225. A first input end of the first AND gate 3222 and a first input end of the second AND gate 3223 are both configured to receive the last bit Y_{N-1} in the first value Y[N-1:0], a second input end of the first AND gate 3222 is configured to receive the first selection signal SM, and a second input end of the second AND gate 3223 is configured to receive the second selection signal S2M. An output end of the first AND gate 3222 and an output end of the second AND gate 3223 are respectively coupled to two input ends of the OR gate 3224, an output end of the OR gate 3224 is coupled to a first input end of the XNOR gate 3225, a second input end of the XNOR gate 3225 is configured to receive the sign bit S₂ₖ, an output end of the XNOR gate 3225 is coupled to an input end of the NOT gate 3221, the output end of the XNOR gate 3225 is configured to output the fourth partial product E₂ₖ, and an output end of the NOT gate 3221 is configured to output the third partial product *E̅₂̅ₖ̅.*

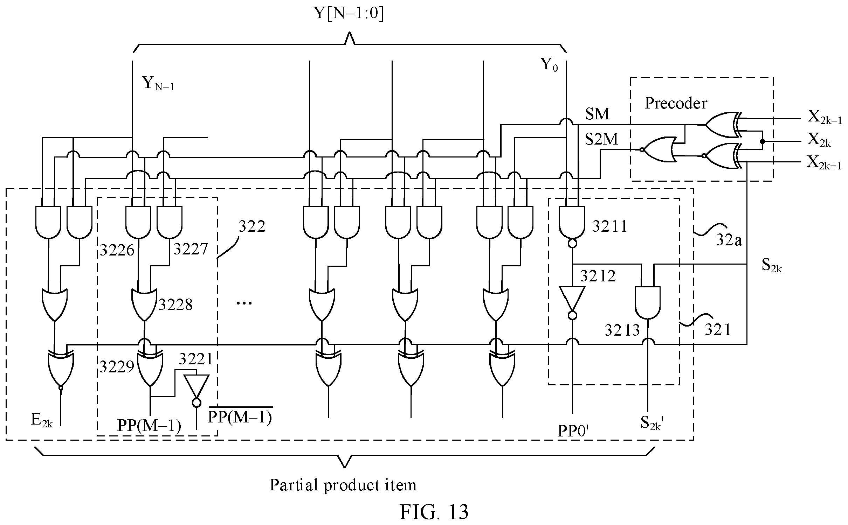

In another example, as shown in FIG. 13, the second partial product is a corresponding partial product PP(M-1) by encoding the last bit Y_{N-1} in the first value Y[N-1:0]. The second encoder 322 alternatively includes a first AND gate 3226, a second AND gate 3227, an OR gate 3228, and an XOR gate 3229. Two input ends of the first AND gate 3226 are respectively configured to receive the last bit Y_{N-1} in the first value Y[N-1:0] and the first selection signal SM, and two input ends of the second AND gate 3227 are respectively configured to receive the penultimate bit Y_{N-2} in the first value Y[N-1:0] and the second selection signal S2M. An output end of the first AND gate 3226, and an output end of the second AND gate 3227 are respectively coupled to two input ends of the OR gate 3228, an output end of the OR gate 3228 is coupled to a first input end of the XOR gate 3229, a second input end of the XOR gate 3229 is configured to receive the sign bit S₂ₖ, an output end of the XOR gate 3229 is coupled to an input end of the NOT gate 3221, the output end of the XOR gate 3229 is configured to output the fourth partial product PP(M-1), and an output end of the NOT gate 3221 is configured to output the third partial product *P̅P̅(̅M̅-̅1̅)̅.*

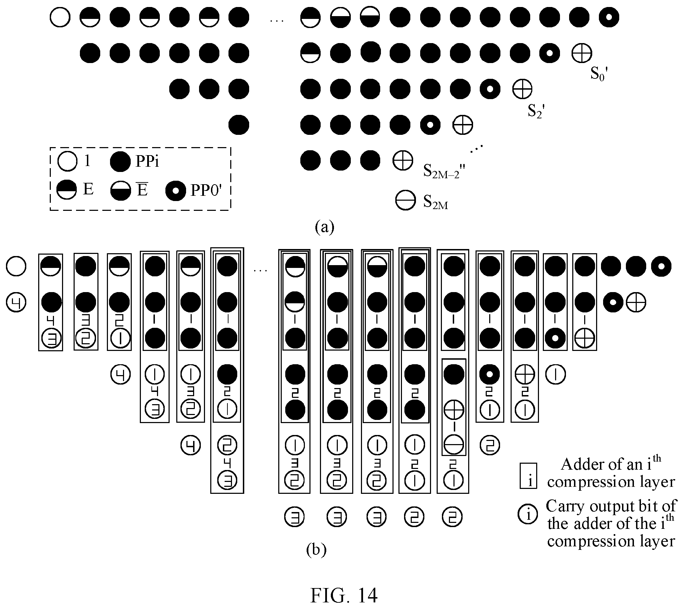

For example, with reference to (a) in FIG. 9, when the P encoder groups 32 use the solution described in FIG. 10 to FIG. 12, the permutation array corresponding to the plurality of partial product items output by the P encoder groups 32 is shown in (a) in FIG. 14. In other words, S_{2M-2}' and S_{2M} shown in (a) in FIG. 9 are replaced with S_{2M-2}" and S_{2M} shown in (a) in FIG. 14, and the constant 1 output in (a) in FIG. 9 is added in advance in the encoding process. Correspondingly, a structure of a plurality of compression layers included in the compressor 33 configured to compress the permutation array is shown in (b) in FIG. 14. In FIG. 14, different points in the permutation array represent different types of partial products (for example, PPi, PP0', a constant 1, a sign extension bit E, an inverse phase *E̅* of the sign extension bit E, a sign bit S2M, and output sign bits S₂ₖ' and S_{2M-2}"). Rectangles with different numbers in the compressor 33 represent adders at different compression layers (for example, the 1^{st} compression layer to the 7^{th} compression layer), rectangles with a same number represent different adders at a same compression layer, and circles with different numbers represent carry output bits obtained by performing compression by the adders at the different compression layers.

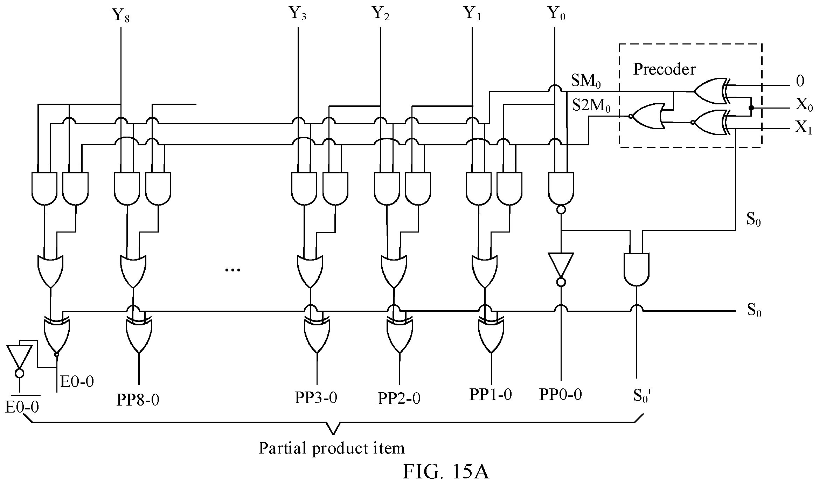

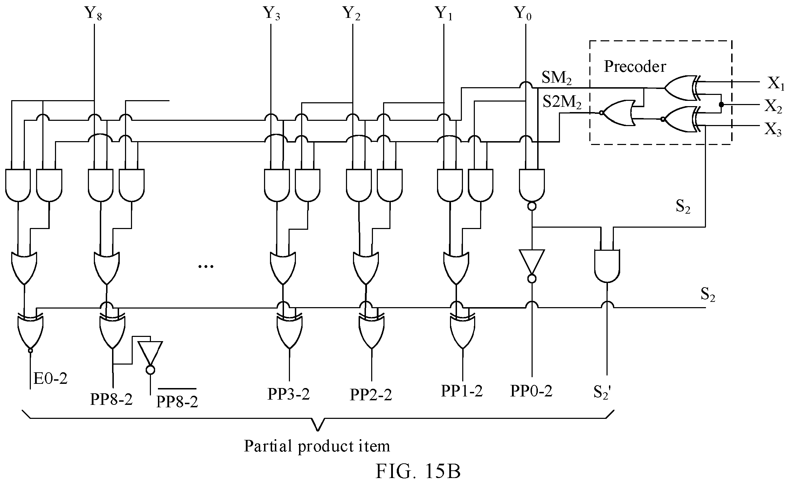

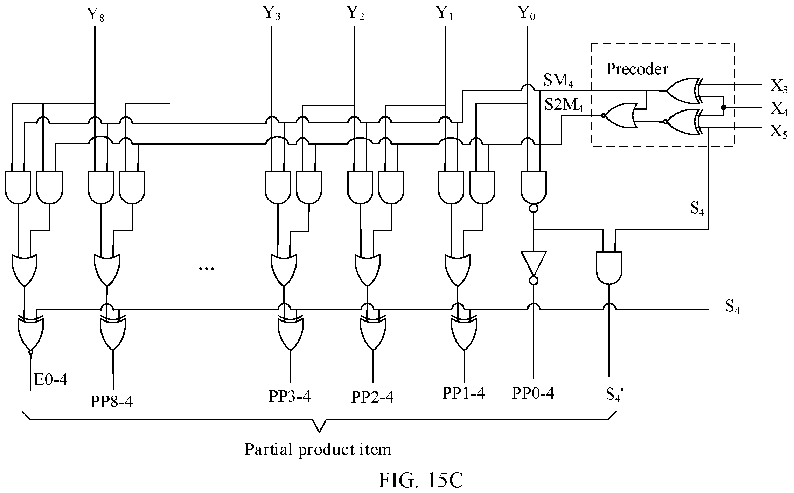

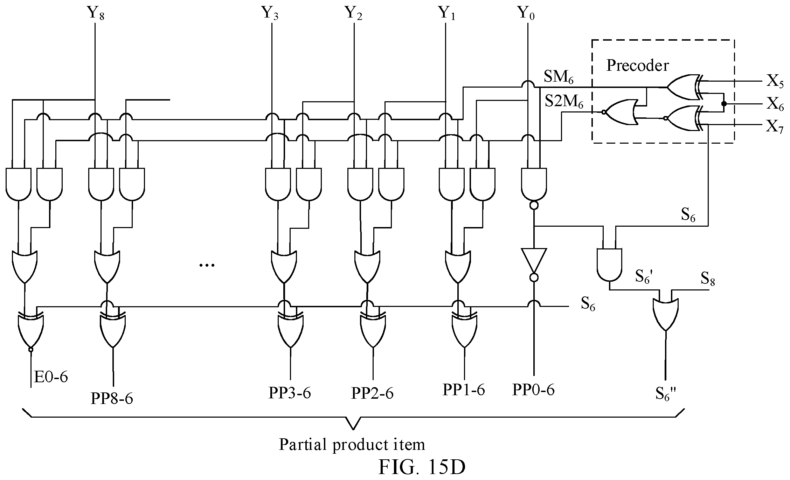

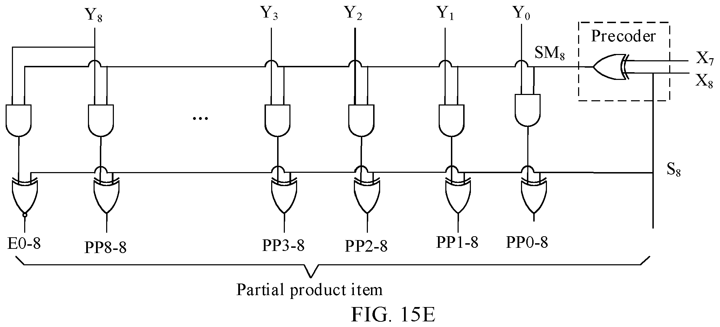

For ease of understanding, an example in which the multiplier provided in this embodiment of this application is a 9 bits×9 bits (that is, Y[8:0]×X[8:0]) multiplier is used. A quantity of P precoders 31 and P encoder groups 32 is equal to 5, and the compressor 33 includes three compression layers. The following describes in detail the five precoders 31, the five encoder groups 32, and the compressor 33. As shown in FIG. 15A, the 1^{st} precoder 31 is configured to: precode 0, X₀, and X₁, to output SM₀ and S2M₀. The 1^{st} encoder group 32 is configured to: encode Y₀ to Y₈ in a first value Y[8:0], SM₀ and S2M₀, and a sign bit S₀, to output a first partial product item (including PP0-0 to PP8-0, E0-0, *̅E̅*̅0̅ -̅ 0̅ and S₀'). As shown in FIG. 15B, the 2^{nd} precoder 31 is configured to: precode X₁, X₂, and X₃, to output SM₂ and S2M₂. The 2^{nd} encoder group 32 is configured to: encode Y₀ to Y₈ in the first value Y[8:0], SM₂ and S2M₂, and a sign bit S₂, to output a first partial product (including PP0-2 to PP8-2, *̅P̅P̅8̅*̅ -̅ *̅2̅*̅, E0-2, and S₂'). As shown in FIG. 15C, the 3^{rd} precoder 31 is configured to: precode X₃, X₄, and X₅, to output SM₄ and S2M₄. The 3^{rd} encoder group 32 is configured to: encode Y₀ to Y₈ in the first value Y[8:0], SM₄ and S2M₄, and a sign bit S₄, to output a first partial product (including PP0-4 to PP8-4, E0-4, and S₄'). As shown in FIG. 15D, the 4^{th} precoder 31 is configured to: precode X₅, X₆, and X₇, to output SM₆ and S2M₆. The 4^{th} encoder group 32 is configured to: encode Y₀ to Y₈ in the first value Y[8:0], SM₆ and S2M₆, and sign bits S₆ and S₈, to output a first partial product (including PP0-6 to PP8-6, E0-6, and S₆"). As shown in FIG. 15E, the 5^{th} precoder 31 is configured to: precode X₇ and X₈, to output SM₈. The 5^{th} encoder group 32 is configured to: encode Y₀ to Y₈ in the first value Y[8:0], SM₈, and a sign bit S₈, to output a first partial product (including PP0-8 to PP8-8, E0-8, and S₈). It should be noted that structures of the precoders and the encoder groups shown in FIG. 15A to FIG. 15E are merely examples. For descriptions of the structure of each precoder and each encoder group, refer to the foregoing related descriptions. Details are not described herein again in this embodiment of this application.

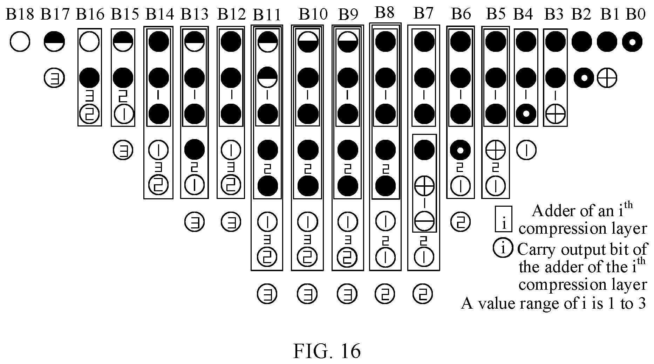

As shown in FIG. 16, the compressor 33 includes three compression layers, the 1^{st} compression layer includes 13 adders, the 2^{nd} compression layer includes nine adders, and the 3^{rd} compression layer includes seven adders. Therefore, the three compression layers include 29 adders in total. Compared with the compressor of the current technology shown in (c) in FIG. 3, a quantity of compression layers in FIG. 16 is reduced by seven, and a total quantity of adders used is reduced by eight. In this way, the quantity of compression layers included in the compressor 33 and the total quantity of adders are greatly reduced, an area of the multiplier is further reduced, and an operation speed of the multiplier is increased. In FIG. 16, B0 to B18 correspondingly represent different digits (to be specific, 2⁰ to 2¹⁸), and different points in the permutation array represent different types of partial products (for details, refer to the descriptions in FIG. 14). Rectangles with different numbers in the compressor 33 represent adders at different compression layers (for example, the 1^{st} compression layer to the 3^{rd} compression layer), rectangles with a same number represent different adders at a same compression layer, and circles with different numbers represent carry output bits obtained by performing compression by the adders at the different compression layers.

In the multiplier provided in this embodiment of this application, the P encoder groups include a first encoder group, the first encoder group includes a first encoder, and the first encoder is configured to encode a first selection signal group, a least significant bit in the first value, and the first sign bit in an encoding process. A partial product obtained by encoding the least significant bit and the first sign bit can be added in advance, so that a permutation array that includes a plurality of partial product items and is output by the P encoder groups is more centralized or regularized. In this way, the quantity of compression layers included in the compressor is reduced, the area of the multiplier is further reduced, and the operation speed of the multiplier is increased. In addition, the multiplier further encodes a first output sign bit and a second sign bit by using the first encoder, and encodes a constant 1 and a second partial product by using a second encoder, so that the permutation array that includes a plurality of partial product items and is output by the P encoder groups is further regularized. In this way, the quantity of compression layers included in the compressor is further reduced, to further reduce the area of the multiplier, and increase the operation speed of the multiplier.

In another embodiment of this application, a processor is further provided. The processor includes a multiplier, where the multiplier is any multiplier provided above.

In another embodiment of this application, a chip is further provided. The chip includes a multiplier, where the multiplier is any multiplier provided above.

In another embodiment of this application, a communication device is further provided. A structure of the communication device may be shown in FIG. 4. In other words, the communication device may include a memory 201, a processor 202, a communication interface 203, and a bus 204. The processor 202 may include any multiplier provided above.

It should be noted that the foregoing related descriptions of the multiplier may be correspondingly referenced to the multipliers included in the processor, the chip, and the communication device. Details are not described herein again in embodiments of this application.

The foregoing descriptions are merely specific implementations of this application, but are not intended to limit a protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A multiplier, configured to implement multiplication of a first value of N bits and a second value of W bits, wherein N and W are integers greater than 1, and the multiplier comprises: P precoders (31), P encoder groups (32), and a compressor (33), wherein the P precoders are in a one-to-one correspondence with the P encoder groups, and P is an integer greater than 1;
each precoder of the P precoders is configured to: precode at least two bits in the second value, to output a selection signal group;
each encoder group of the P encoder groups is configured to: encode the first value and a selection signal group output by a precoder corresponding to the encoder group, to output a partial product item, wherein the partial product item comprises a plurality of partial products, and the P encoder groups correspondingly output P partial product items, wherein
the P encoder groups comprise a first encoder group (32a), the first encoder group comprises a first encoder (321), the first encoder is configured to: encode a first selection signal group, a least significant bit in the first value, and a first sign bit, to obtain a first partial product and a first output sign bit, wherein a digit corresponding to the first output sign bit is greater than a digit corresponding to the first sign bit and a difference value is 1, the first selection signal group is a selection signal group output by a first precoder of the P precoders, the first sign bit is one of the at least two bits used by the first precoder when performing encoding, and the first precoder corresponds to the first encoder group; and
the compressor is configured to: compress the P partial product items, to obtain a plurality of accumulated values, wherein a sum of the plurality of accumulated values is a product of the first value and the second value.

2. The multiplier according to claim 1, wherein the first selection signal group comprises a first selection signal, the first encoder (321) comprises a first NAND gate (3211), a first NOT gate (3212), and a first AND gate (3213), and an output end of the first NAND gate is coupled to an input end of the first NOT gate and a first input end of the first AND gate, wherein
two input ends of the first NAND gate are respectively configured to receive the least significant bit and the first selection signal, an output end of the first NOT gate is configured to output the first partial product, a second input end of the first AND gate is configured to receive the first sign bit, and an output end of the first AND gate is configured to output the first output sign bit.

3. The multiplier according to claim 1 or 2, wherein the P encoder groups (32) comprise P-1 first encoder groups (32a, 32b).

4. The multiplier according to any one of claims 1 to 3, wherein the first encoder (321) is further configured to:
encode the first output sign bit and a second sign bit, to obtain a second output sign bit, wherein the second sign bit is a sign bit used by a precoder (31) corresponding to a next encoder group of the first encoder group (32a) when performing encoding, and a digit of the second sign bit in the partial product item is the same as a digit of the second output sign bit.

5. The multiplier according to claim 4, wherein the first encoder (321) further comprises an OR gate (3214); and
two input ends of the OR gate are respectively configured to receive the first output sign bit and the second sign bit, an output end of the OR gate is configured to output the second output sign bit.

6. The multiplier according to claim 4 or 5, wherein a (P-1)^{th} encoder group of the P encoder groups (32) is the first encoder group (32a).

7. The multiplier according to any one of claims 1 to 6, wherein at least one encoder group of the P encoder groups (32) further comprises a second encoder (322); and
the second encoder is configured to: encode a constant 1 and a second partial product, to obtain a third partial product and a fourth partial product, the second partial product is a sign extension bit in a partial product item output by an encoder group (32b) in which the second encoder is located or a partial product corresponding to an encoded bit in the first value, the third partial product and the second partial product correspond to a same digit, and a digit corresponding to the fourth partial product is greater than the digit corresponding to the third partial product and a difference value is 1.

8. The multiplier according to claim 7, wherein the second encoder (322) comprises a second NOT gate (3221); and
an input end of the second NOT gate is configured to receive the second partial product, an output end of the second NOT gate is configured to output the third partial product, and the fourth partial product is equal to the second partial product.

9. The multiplier according to any one of claims 1 to 8, wherein W is an odd number.

10. The multiplier according to any one of claims 1 to 9, wherein the P encoder groups (32) further comprise a second encoder group (32b), and the second encoder group is different from the first encoder group (32a).

11. The multiplier according to any one of claims 1 to 10, wherein the multiplier further comprises:
a summation circuit (34), configured to: receive the plurality of accumulated values, and sum the plurality of accumulated values to obtain the product.

12. A processor (202), wherein the processor comprises the multiplier according to any one of claims 1 to 11.

13. A communication device, wherein the communication device comprises the multiplier according to any one of claims 1 to 11.

## Patentansprüche

1. Multiplizierer, der dazu konfiguriert ist, eine Multiplikation eines ersten Wertes von N Bits und eines zweiten Wertes von W Bits durchzuführen, wobei N und W ganze Zahlen größer als 1 sind und der Multiplizierer Folgendes umfasst: P Vorcodierer (31), P Codierergruppen (32) und einen Kompressor (33), wobei die P Vorcodierer in einer Eins-zu-Eins-Entsprechung mit den P Codierergruppen stehen und P eine ganze Zahl größer als 1 ist;
jeder Vorcodierer der P Vorcodierer zu Folgendem konfiguriert ist: Vorcodieren mindestens zweier Bits in dem zweiten Wert, um eine Auswahlsignalgruppe auszugeben;
jede Codierergruppe der P Codierergruppen zu Folgendem konfiguriert ist: Codieren des ersten Wertes und einer Auswahlsignalgruppe, die durch einen Vorcodierer ausgegeben wird, welcher der Codierergruppe entspricht, um einen Teilprodukteintrag auszugeben, wobei der Teilprodukteintrag eine Vielzahl von Teilprodukten umfasst und die P Codierergruppen entsprechend P Teilprodukteinträge ausgeben, wobei
die P Codierergruppen eine erste Codierergruppe (32a) umfassen, die erste Codierergruppe einen ersten Codierer (321) umfasst, der erste Codierer zu Folgendem konfiguriert ist: Codieren einer ersten Auswahlsignalgruppe, eines am wenigsten signifikanten Bits in dem ersten Wert und eines ersten Zeichenbits, um ein erstes Teilprodukt und ein erstes ausgegebenes Zeichenbit zu erlangen, wobei eine Ziffer, die dem ersten ausgegebenen Zeichenbit entspricht, größer als eine Ziffer ist, die dem ersten Zeichenbit entspricht, und ein Differenzwert 1 ist, die erste Auswahlsignalgruppe eine Auswahlsignalgruppe ist, die durch einen ersten Vorcodierer der P Vorcodierer ausgegeben wird, das erste Zeichenbit eines der mindestens zwei Bits ist, die bei Durchführen des Codierens durch den ersten Vorcodierer verwendet werden, und der erste Vorcodierer der ersten Codierergruppe entspricht; und
der Kompressor zu Folgendem konfiguriert ist: Komprimieren der P Teilprodukteinträge, um eine Vielzahl akkumulierter Werte zu erlangen, wobei eine Summe der Vielzahl akkumulierter Werte ein Produkt des ersten Wertes und des zweiten Wertes ist.

2. Multiplizierer nach Anspruch 1, wobei die erste Auswahlsignalgruppe ein erstes Auswahlsignal umfasst, der erste Codierer (321) ein erstes NAND-Gatter (3211), ein erstes NOT-Gatter (3212) und ein erstes AND-Gatter (3213) umfasst und ein Ausgabeende des ersten NAND-Gatters mit einem Eingabeende des ersten NOT-Gatters und einem ersten Eingabeende des ersten AND-Gatters verbunden ist, wobei
zwei Eingabeenden des ersten NAND-Gatters jeweils dazu konfiguriert sind, das am wenigsten signifikante Bit und das erste Auswahlsignal zu empfangen, ein Ausgabeende des ersten NOT-Gatters dazu konfiguriert ist, das erste Teilprodukt auszugeben, ein zweites Eingabeende des ersten AND-Gatters dazu konfiguriert ist, das erste Zeichenbit zu empfangen, und ein Ausgabeende des ersten AND-Gatters dazu konfiguriert ist, das erste ausgegebene Zeichenbit auszugeben.

3. Multiplizierer nach Anspruch 1 oder 2, wobei die P Codierergruppen (32) P-1 erste Codierergruppen (32a, 32b) umfassen.

4. Multiplizierer nach einem der Ansprüche 1 bis 3, wobei der erste Codierer (321) ferner zu Folgendem konfiguriert ist:
Codieren des ersten ausgegebenen Zeichenbits und eines zweiten Zeichenbits, um ein zweites ausgegebenes Zeichenbit zu erlangen, wobei das zweite Zeichenbit ein Zeichenbit ist, das bei dem Durchführen des Codierens durch einen Vorcodierer (31) verwendet wird, der einer nächsten Codierergruppe der ersten Codierergruppe (32a) entspricht, und eine Ziffer des zweiten Zeichenbits in dem Teilprodukteintrag die gleiche wie eine Ziffer des zweiten ausgegebenen Zeichenbits ist.

5. Multiplizierer nach Anspruch 4, wobei der erste Codierer (321) ferner ein OR-Gatter (3214) umfasst; und
zwei Eingabeenden des OR-Gatters jeweils dazu konfiguriert sind, das erste ausgegebene Zeichenbit und das zweite Zeichenbit zu empfangen, wobei ein Ausgabeende des OR-Gatters dazu konfiguriert ist, das zweite ausgegebene Zeichenbit auszugeben.

6. Multiplizierer nach Anspruch 4 oder 5, wobei eine (P-1)-te Codierergruppe der P Codierergruppen (32) die erste Codierergruppe (32a) ist.

7. Multiplizierer nach einem der Ansprüche 1 bis 6, wobei mindestens eine Codierergruppe der P Codierergruppen (32) ferner einen zweiten Codierer (322) umfasst; und
der zweite Codierer zu Folgendem konfiguriert ist: Codieren einer Konstante 1 und eines zweiten Teilprodukts, um ein drittes Teilprodukt und ein viertes Teilprodukt zu erlangen, das zweite Teilprodukt ein Zeichenerweiterungsbit in einem Teilprodukteintrag, der durch eine Codierergruppe (32b) ausgegeben wird, in der sich der zweite Codierer befindet, oder ein Teilprodukt ist, das einem codierten Bit in dem ersten Wert entspricht, das dritte Teilprodukt und das zweite Teilprodukt einer gleichen Ziffer entsprechen und eine Ziffer, die dem vierten Teilprodukt entspricht, größer als die Ziffer ist, die dem dritten Teilprodukt entspricht, und ein Differenzwert 1 ist.

8. Multiplizierer nach Anspruch 7, wobei der zweite Codierer (322) ein zweites NOT-Gatter (3221) umfasst; und
ein Eingabeende des zweiten NOT-Gatters dazu konfiguriert ist, das zweite Teilprodukt zu empfangen, ein Ausgabeende des zweiten NOT-Gatters dazu konfiguriert ist, das dritte Teilprodukt auszugeben, und das vierte Teilprodukt gleich dem zweiten Teilprodukt ist.

9. Multiplizierer nach einem der Ansprüche 1 bis 8, wobei W eine ungerade Zahl ist.

10. Multiplizierer nach einem der Ansprüche 1 bis 9, wobei die P Codierergruppen (32) ferner eine zweite Codierergruppe (32b) umfassen und sich die zweite Codierergruppe von der ersten Codierergruppe (32a) unterscheidet.

11. Multiplizierer nach einem der Ansprüche 1 bis 10, wobei der Multiplizierer ferner Folgendes umfasst:
eine Summierschaltung (34), die zu Folgendem konfiguriert ist: Empfangen der Vielzahl akkumulierter Werte und Summieren der Vielzahl akkumulierter Werte, um das Produkt zu erlangen.

12. Prozessor (202), wobei der Prozessor den Multiplizierer nach einem der Ansprüche 1 bis 11 umfasst.

13. Kommunikationsvorrichtung, wobei die Kommunikationsvorrichtung den Multiplizierer nach einem der Ansprüche 1 bis 11 umfasst.

## Revendications

1. Multiplicateur, configuré pour mettre en œuvre la multiplication d'une première valeur de N bits et d'une seconde valeur de W bits, dans lequel N et W sont des entiers supérieurs à 1, et le multiplicateur comprend : P précodeurs (31), P groupes de codeurs (32) et un compresseur (33), dans lequel les P précodeurs sont en correspondance biunivoque avec les P groupes de codeurs, et P est un entier supérieur à 1 ;
chaque précodeur des P précodeurs est configuré pour : précoder au moins deux bits dans la seconde valeur, pour émettre un groupe de signaux de sélection ;
chaque groupe de codeurs des P groupes de codeurs est configuré pour : coder la première valeur et un groupe de signaux de sélection émis par un précodeur correspondant au groupe de codeurs, afin d'émettre un élément de produit partiel, dans lequel l'élément de produit partiel comprend une pluralité de produit partiels, et les P groupes de codeurs émettent en conséquence P éléments de produit partiels, dans lequel
les P groupes de codeurs comprennent un premier groupe de codeurs (32a), le premier groupe de codeurs comprend un premier codeur (321), le premier codeur est configuré pour : coder un premier groupe de signaux de sélection, un bit moins significatif de la première valeur et un premier bit de signe, afin d'obtenir un premier produit partiel et un premier bit de signe de sortie, dans lequel un chiffre correspondant au premier bit de signe de sortie est supérieur à un chiffre correspondant au premier bit de signe, et une valeur de différence est de 1, le premier groupe de signaux de sélection est un groupe de signaux de sélection émis par un premier précodeur parmi les P précodeurs, le premier bit de signe est l'un des au moins deux bits utilisés par le premier précodeur lors de la réalisation du codage, et le premier précodeur correspond au premier groupe de codeurs ; et
le compresseur est configuré pour : compresser les P éléments de produit partiels, afin d'obtenir une pluralité de valeurs accumulées, dans lequel une somme de la pluralité de valeurs accumulées est un produit de la première valeur et de la seconde valeur.

2. Multiplicateur selon la revendication 1, dans lequel le premier groupe de signaux de sélection comprend un premier signal de sélection, le premier codeur (321) comprend une première porte NAND (3211), une première porte NOT (3212) et une première porte AND (3213), et une extrémité de sortie de la première porte NAND est couplée à une extrémité d'entrée de la première porte NOT et à une première extrémité d'entrée de la première porte AND, dans lequel
deux extrémités d'entrées de la première porte NAND sont respectivement configurées pour recevoir le bit le moins significatif et le premier signal de sélection, une extrémité de sortie de la première porte NOT est configurée pour émettre le premier produit partiel, une seconde extrémité d'entrée de la première porte AND est configurée pour recevoir le premier bit de signe, et une extrémité de sortie de la première porte AND est configurée pour émettre le premier bit de signe de sortie.

3. Multiplicateur selon la revendication 1 ou 2, dans lequel les P groupes de codeurs (32) comprennent des P-1 premiers groupes de codeurs (32a, 32b).

4. Multiplicateur selon l'une quelconque des revendications 1 à 3, dans lequel le premier codeur (321) est en outre configuré pour :
coder le premier bit de signe de sortie et un second bit de signe, afin d'obtenir un second bit de signe de sortie, dans lequel le second bit de signe est un bit de signe utilisé par un précodeur (31) correspondant à un groupe de codeurs suivant du premier groupe de codeurs (32a) lors de la réalisation du codage, et un chiffre du second bit de signe dans l'élément de produit partiel est le même qu'un chiffre du second bit de signe de sortie.

5. Multiplicateur selon la revendication 4, dans lequel le premier codeur (321) comprend en outre une porte OR (3214) ; et deux extrémités d'entrée de la porte OR sont respectivement configurées pour recevoir le premier bit de signe de sortie et le second bit de signe, une extrémité de sortie de la porte OR est configurée pour émettre le second bit de signe de sortie.

6. Multiplicateur selon la revendication 4 ou 5, dans lequel un (P-1)^{ème} groupe de codeurs des P groupes de codeurs (32) est le premier groupe de codeurs (32a).

7. Multiplicateur selon l'une quelconque des revendications 1 à 6, dans lequel au moins un groupe de codeurs des P groupes de codeurs (32) comprend en outre un second codeur (322) ; et
le second codeur est configuré pour : coder une constante 1 et un deuxième produit partiel, afin d'obtenir un troisième produit partiel et un quatrième produit partiel, le deuxième produit partiel est un bit d'extension de signe dans un élément de produit partiel émis par un groupe de codeurs (32b) dans lequel se trouve le second codeur ou un produit partiel correspondant à un bit codé dans la première valeur, le troisième produit partiel et le deuxième produit partiel correspondent à un même chiffre, et un chiffre correspondant au quatrième produit partiel est supérieur au chiffre correspondant au troisième produit partiel et une valeur de différence est de 1.

8. Multiplicateur selon la revendication 7, dans lequel le second codeur (322) comprend une seconde porte NOT (3221) ; et
une extrémité d'entrée de la seconde porte NOT est configurée pour recevoir le deuxième produit partiel, une extrémité de sortie de la seconde porte NOT est configurée pour émettre le troisième produit partiel, et le quatrième produit partiel est égal au deuxième produit partiel.

9. Multiplicateur selon l'une quelconque des revendications 1 à 8, dans lequel W est un nombre impair.

10. Multiplicateur selon l'une quelconque des revendications 1 à 9, dans lequel les P groupes de codeurs (32) comprennent en outre un second groupe de codeurs (32b), et le second groupe de codeurs est différent du premier groupe de codeurs (32a).

11. Multiplicateur selon l'une quelconque des revendications 1 à 10, dans lequel le multiplicateur comprend en outre :
un circuit de sommation (34), configuré pour : recevoir la pluralité des valeurs accumulées et additionner la pluralité des valeurs accumulées pour obtenir le produit.

12. Processeur (202), dans lequel le processeur comprend le multiplicateur selon l'une quelconque des revendications 1 à 11.

13. Dispositif de communication, dans lequel le dispositif de communication comprend le multiplicateur selon l'une quelconque des revendications 1 à 11.
